# EUROPEAN PATENT SPECIFICATION

(11) **EP 4 113 520 B1**
(45) Date of publication and mention of the grant of the patent: **18.11.2026**
(21) Application number: 21183406.4
(22) Date of filing: 02.07.2021
(51) Int. Cl.: G11C 11/401, G11C 11/42, G11C 13/04, G06K 19/07

(54) **STORAGE DEVICE AND METHOD OF PRODUCING THE SAME**
SPEICHERVORRICHTUNG UND VERFAHREN ZUR HERSTELLUNG DAVON
DISPOSITIF DE STOCKAGE ET SON PROCÉDÉ DE PRODUCTION

(43) Date of publication of application: 04.01.2023
(73) Proprietor: NXP B.V., 5656 AG Eindhoven (NL)
(72) Inventor: ZACHARIASSE, Frank, 5656 AG Eindhoven (NL); MALINOWSKI, Slawomir Rafal, 5656 AG Eindhoven (NL); HENES NETO, Egas Carvalho, 5656 AG Eindhoven (NL); ALI, Shafqat, 5656 AG Eindhoven (NL)
(74) Representative: Krott, Michel

(56) References cited:
- WO-A1-99/30368
- US-A1- 2020 346 004

## Description

### TECHNICAL FIELD

The present disclosure relates to a storage device. Furthermore, the present disclosure relates to a corresponding method of producing a storage device.

### BACKGROUND

Storage devices based on the principle of maintaining a predefined charge on a capacitor are widely used. For instance, such storage devices may be used as so-called persistent flags in transponders. Nowadays, radio frequency identification (RFID) transponders are widely used, in different areas of industry and commerce and for various purposes. RFID transponders may for example be embodied as so-called RFID tags or RFID cards. It is noted that, in the present disclosure, near field communication (NFC) transponders are regarded as a specific type of RFID transponders. Thus, the principles described herein may also be applied to NFC transponders.

WO 99/30368 A1 describes a high sensitivity active pixel for use in MOS image sensor circuits, which allows digital MOS fabrication processes to be used in implementing a pixel circuit having high sensitivity (allowing increased frame rate) and high noise immunity. The pixel features a source follower configured amplifier, such as a single MOS FET, coupled between a photodetector and a storage capacitor. A light-generated signal from the photodetector is used to control the charge placed in the storage capacitor in order to develop a capture voltage.

US 2020/346004 A1 describes an optical sensor, especially an artificial retina, that includes at least one photosensitive cell. Each cell includes a integration capacitor, a read circuit the operation of which depends on the charge of the integration capacitor at least one MOS transistor operating subthreshold, and the drain-source current of which influences the charge on the integration capacitor, and at least one photodiode operating in photovoltaic mode and connected to the gate of this transistor, such that the drain-source current of the MOS transistor depends on the optical power received by the photodiode.

### SUMMARY

In accordance with a first aspect of the present disclosure, a storage device is provided, as defined in claim 1.

In one or more embodiments, reducing the input voltage causes a layer of holes to be created around the source.

In one or more embodiments, the transponder is a radio frequency identification transponder or a near field communication transponder.

In one or more embodiments, the device further comprises an output circuit coupled between the pass device and the capacitor, wherein the output circuit is configured to output a voltage present on the capacitor.

In one or more embodiments, a charging state of the capacitor represents information to be retained, in particular a bit.

In one or more embodiments, a transponder, in particular a radio frequency identification transponder or a near field communication transponder, comprises a storage device of the kind set forth.

In accordance with a second aspect of the present disclosure, a method of producing a storage device is conceived, as defined in claim 7.

In one or more embodiments, reducing the input voltage causes a layer of holes to be created around the source.

In one or more embodiments, the transponder is a radio frequency identification transponder or a near field communication transponder.

Embodiments will be described in more detail with reference to the appended drawings, in which:
Fig. 1 shows an example of a storage device;
Fig. 2 shows an example of a persistence time associated with a storage device;
Fig. 3 shows another example of a storage device;
Fig. 4 shows an example of a pass device comprised in a storage device;
Fig. 5 shows an illustrative embodiment of a storage device;
Fig. 6 shows an illustrative embodiment of a pass device comprised in a storage device.

Only embodiments comprising all the features of independent device claim 1 or of independent method claim 7 fall under the scope of protection of the present invention.

### DESCRIPTION OF EMBODIMENTS

As mentioned above, storage devices based on the principle of maintaining a predefined charge on a capacitor are widely used. For instance, such storage devices may be used as so-called persistent flags in transponders. Nowadays, radio frequency identification (RFID) transponders are widely used, in different areas of industry and commerce and for various purposes. RFID transponders may for example be embodied as so-called RFID tags or RFID cards. It is noted that, in the present disclosure, near field communication (NFC) transponders are regarded as a specific type of RFID transponders. Thus, the principles described herein may also be applied to NFC transponders.

Persistent flags are a feature related to the RFID technology. The persistent flags have the function to retain the inventory state information of a transponder for a predetermined or predefined time. This predetermined time is often referred to as the persistence time. The function and the time requirements of each persistent flag are specified in a protocol, which is an industry standard defining the communication between a reader and a transponder, and vice versa. Such a protocol is for example defined in the document EPC™ Radio-Frequency Identity Protocols Generation-2 UHF RFID, version 2.0.1, published in April 2015. It is noted that reference is made to a tag in the examples and embodiments described herein. However, the presently disclosed storage device may also be used in other types of transponders or other devices.

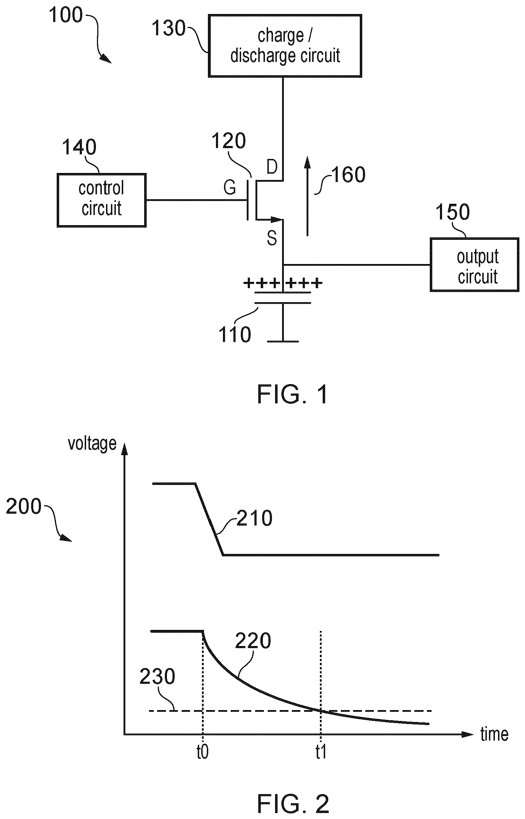

**Fig. 1** shows an example of a storage device 100. In particular, Fig. 1 shows a possible implementation of a persistent flag, such as described in US 8,803,592 B2. The implementation is formed by a capacitor 110, a pass device 120, a charge/discharge circuit 130, a control circuit 140 and an output circuit 150. During the normal operation of a tag, in other words, when the tag is powered, the persistence flag can be set or reset. The set operation is performed by charging the capacitor 110 by enabling control through both the charge circuit 130 and the control circuit 140. The resulting charged voltage across the capacitor 110 is defined by the voltage applied at the gate and drain terminals of the pass device 120 and the threshold voltage of the pass device 120. The persistence time, which is associated with the charged voltage across the capacitor 110, is counted from the time when the tag becomes unpowered to the time when the voltage across the capacitor 110 falls below the threshold of a comparison function of the output circuit 150.

**Fig. 2** shows an example of a persistence time 200 associated with the storage device 100 shown in Fig. 1. In particular, the time diagram shows that at t0 the tag becomes unpowered 210 and that consequently the voltage across the previously charged capacitor starts to decrease 220. At t1, the voltage across the capacitor falls below the threshold 230 of the comparison function of the output circuit. The persistence time is defined as the difference t1 - t0. The parameters which influence the persistence time are the charge in the capacitor and the leakage current connected to the capacitor. In the circuit implementation illustrated in Fig. 1, the dominant current leakage source is the channel leakage of the pass device, which is an NMOS pass device.

Storage devices of the kind set form may be sensitive to light. For instance, it has been reported in US 9,218,519 B2 that persistent flags are sensitive to light. This means that the persistence time can be decreased significantly when the tag is exposed to the light. Once entering in the semiconductor material, energetic photons can create electron-hole pairs, which generate charge carriers. The photo generated charge carriers will diffuse through the semiconductor bulk and part of them will reach p-n junctions, resulting in a current flow (or photocurrent) which might perturb the operation of low power circuits. Another part of the of the photo-generated charge carriers may recombine with the semiconductor material before reaching the p-n junctions, in which case no photocurrent is generated.

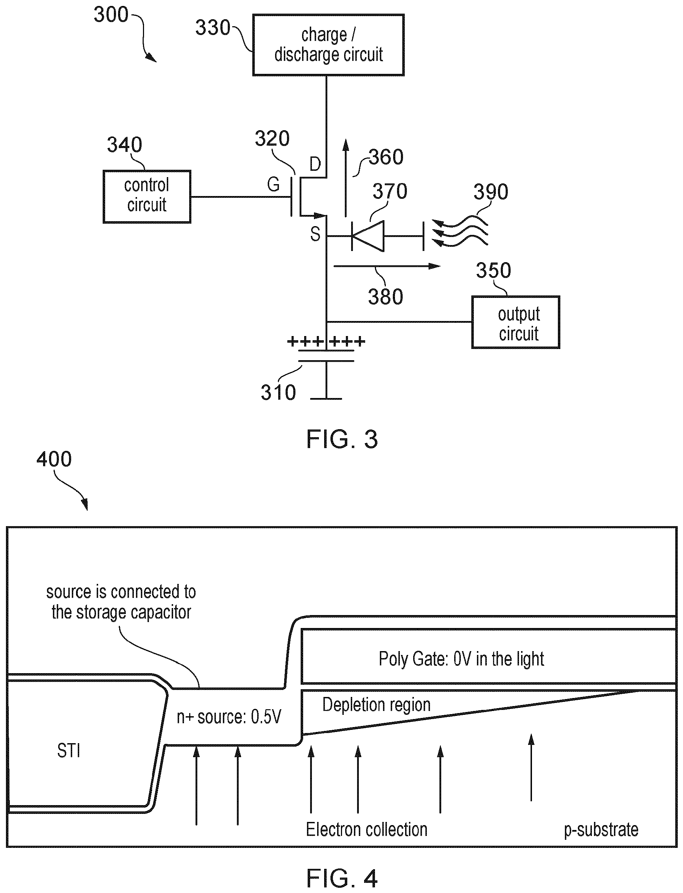

**Fig. 3** shows another example of a storage device 300. In particular, a storage device 300 is shown whose persistence time is affected by light 390. The storage device 300 is implemented as a persistent flag, having a p-n junction 370 associated with the source terminal of the pass device 320. Since the tag is exposed to the light 390, an additional current flow, here denoted as photocurrent 380, is created through the p-n junction at the source terminal of the pass device 320. Depending on the light intensity, the photocurrent could be the dominant one once compared with the leakage 360 of the pass device, and therefore, it would reduce the charge on the storage capacitor 310 rapidly, resulting in a decreased persistence time.

**Fig. 4** shows an example of a pass device 400 comprised in a storage device of the kind set forth. In particular, Fig. 4 shows the cross-sectional view of the pass device presented in schematic form in Fig. 1. More specifically, it shown that in a situation in which the tag is unpowered, the gate voltage of the pass device is 0V and the storage voltage in the capacitor is 0.5V. Since the gate voltage of the pass device is 0V, a depletion region is formed under the gate. Once the tag is exposed to light, the depletion region contributes to increasing the electron collection area, causing an increased photocurrent and a decreased persistence time.

Now discussed are a storage device and a corresponding method of producing a storage device, which facilitate maintaining the persistence time at an acceptable level. In particular, the presently disclosed storage device and corresponding production method facilitate avoiding that a storage capacitor included in the storage device discharges too quickly when the storage device is exposed to light.

According to a first aspect of the present disclosure, a storage device is provided. The storage device comprises a capacitor configured to be charged, a charge circuit configured to charge said capacitor, a pass device coupled between the charge circuit and the capacitor, and a control circuit configured to control said pass device. Furthermore, the storage device comprises a photosensitive diode coupled between the control circuit and the pass device, such that an input voltage provided by the control circuit to the pass device is reduced if the storage device is exposed to light. By including the photosensitive diode, it may be avoided that the capacitor discharges too quickly when the storage device is exposed to light. This, in turn, facilitates maintaining the persistence time at an acceptable level.

The pass device comprises a drain coupled to the charge circuit, a source coupled to the capacitor, and a gate coupled to the control circuit, and the input voltage is the gate voltage of the pass device. This results in a practical implementation of a storage device, whose persistence time is less affected by light. Furthermore, in one or more embodiments, reducing the input voltage causes a layer of holes to be created around the source. For instance, said layer may be an accumulation layer. This further facilitates avoiding that the capacitor discharges too quickly when the storage device is exposed to light. The photosensitive diode contains a cathode terminal which is implemented as an n-well region connected to the gate and an anode terminal implemented as a p-substrate. Furthermore, the p-substrate is a p-substrate of a transponder in which the storage device is included, such that a p-substrate that is already available may be reused for the purpose of reducing the light sensitivity of the storage device.

In one or more embodiments, the storage device comprises an output circuit coupled between the pass device and the capacitor, wherein the output circuit is configured to output a voltage present on the capacitor. In this way, the stored charge may easily be measurement and compared with the threshold, to output a value corresponding to, for example, a charged state or a discharged state. Accordingly, the charging state (i.e. charged or discharged) of the capacitor may represent information to be retained, in particular a bit. It is noted that the measurement function and comparison function of the output circuit may be implemented in a conventional manner.

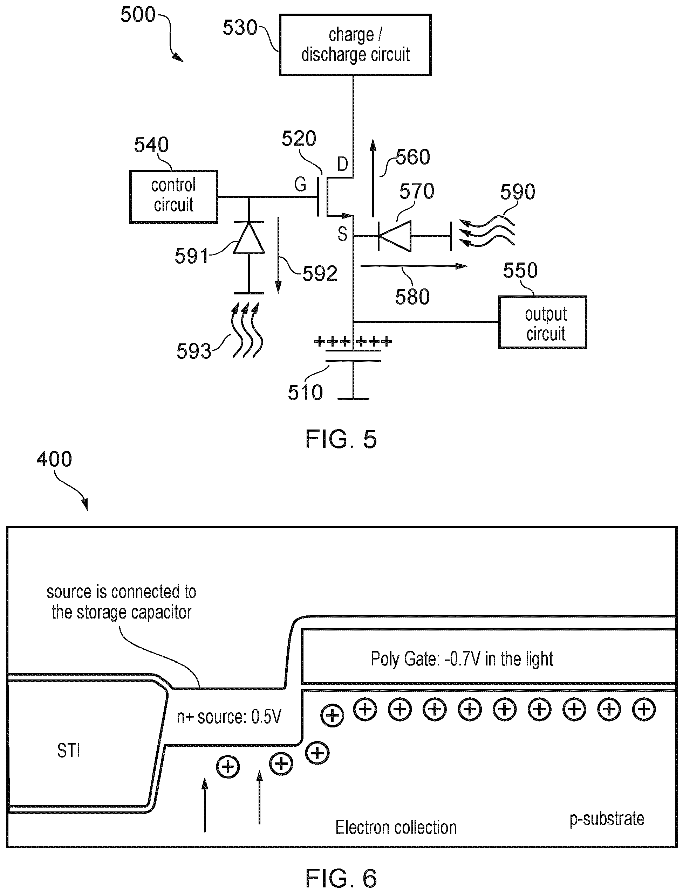

**Fig. 5** shows an illustrative embodiment of a storage device 500. In particular, Fig. 5 shows an example of an implementation of a storage device having a reduced sensitivity to light. The storage device 500 is implemented as a persistent flag, having a diode 591 placed at the gate of the pass device 520. The diode is implemented by connecting the gate to an n-well region in such a way that the cathode terminal of the diode is the n-well region itself, while the anode terminal of the diode is the p-substrate of the tag. The n-well region of the diode can collect photo-generated electrons 593 and consequently a current flow 592 is created in order to pull the gate terminal of the pass device 520 negative.

**Fig. 6** shows an illustrative embodiment of a pass device 600 comprised in a storage device in accordance with the present disclosure. In particular, Fig. 6 illustrates a cross-sectional view of the pass device presented in schematic form in Fig. 5. More specifically, it is shown that in a situation in which the tag is unpowered, the gate voltage of the pass device is -0.7V and the storage voltage in the capacitor is 0.5V. Since the gate voltage of the pass device is -0.7V, the depletion region present in the situation illustrated in Fig. 4 disappears, and an accumulation layer of holes is created around the source terminal of the pass device. Once the tag is exposed to light, the accumulation layer contributes to increasing the recombination electron-holes around the source terminal of the pass device, causing a decreased photocurrent and an increased persistence time.

Thus, the presently disclosed storage device may have the following advantage. The magnitude of the photocurrent of the p-n junction associated with the source terminal of the pass device may be reduced, by decreasing the gate voltage of the pass device at light conditions, reducing therefore the light sensitivity of the persistence time. In a practical implementation, the insertion of a photosensitive diode at the gate of the pass device of a persistent flag decreases the gate voltage (i.e. pulls it below GND) of the pass device at light conditions, reducing in this way the light sensitivity of the persistence time.

It is noted that the embodiments above have been described with reference to different subject-matters. In particular, some embodiments may have been described with reference to method-type claims whereas other embodiments may have been described with reference to apparatus-type claims.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of protection of the present invention as defined by the appended claims 1-9. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

### LIST OF REFERENCE SIGNS

- 100: storage device
- 110: capacitor
- 120: pass device
- 130: charge/discharge circuit
- 140: control circuit
- 150: output circuit
- 160: channel leakage of the pass device
- 200: persistence time
- 210: input power
- 220: voltage across the capacitor
- 230: threshold of the output circuit
- 300: storage device
- 310: capacitor
- 320: pass device
- 330: charge/discharge circuit
- 340: control circuit
- 350: output circuit
- 360: channel leakage of the pass device
- 370: p-n junction
- 380: photocurrent
- 390: light
- 400: cross-sectional view of the pass device
- 500: storage device
- 510: capacitor
- 520: pass device
- 530: charge/discharge circuit
- 540: control circuit
- 550: output circuit
- 560: channel leakage of the pass device
- 570: p-n junction
- 580: photocurrent
- 590: light
- 591: photosensitive diode
- 592: current flow
- 593: photo-generated electrons
- 600: cross-sectional view of the pass device

## Claims

1. A storage device (500), comprising:
- a capacitor (510) configured to be charged;
- a charge circuit (530) configured to charge said capacitor (510);
- a pass device (520) coupled between the charge circuit (530) and the capacitor (510);
- a control circuit (540) configured to control said pass device (520);
- a photosensitive diode (591) coupled between the control circuit (540) and the pass device (520), such that an input voltage provided by the control circuit (540) to the pass device (520) is reduced when the storage device (500) is exposed to light;
wherein the pass device (520) comprises a drain coupled to the charge circuit (530), a source coupled to the capacitor (510), and a gate coupled to the control circuit (540), and wherein said input voltage is the gate voltage of the pass device (520);
**characterized in that** the photosensitive diode (591) contains a cathode terminal which is implemented as an n-well region connected to the gate and an anode terminal implemented as a p-substrate of a transponder in which the storage device (500) is included.

2. The storage
device (500) of claim 1, wherein reducing the input voltage causes a layer of holes to be created around the source.

3. The storage
device (500) of claim 1 or 2, wherein the transponder is a radio frequency identification transponder or a near field communication transponder.

4. The storage
device (500) of any preceding claim, further comprising an output circuit (550) coupled between the pass device (520) and the capacitor (510), wherein the output circuit (550) is configured to output a voltage present on the capacitor (510).

5. The storage
device (500) of any preceding claim, wherein a charging state of the capacitor (510) represents information to be retained, in particular a bit.

6. A transponder, in particular a radio frequency identification transponder or a near field communication transponder, comprising the storage device (500) of any preceding claim.

7. A method of producing a storage device (500), the method comprising providing the storage device with:
- a capacitor (510) configured to be charged;
- a charge circuit (530) configured to charge said capacitor (510);
- a pass device (520) coupled between the charge circuit (530) and the capacitor (510);
- a control circuit (540) configured to control said pass device (520);
- a photosensitive diode (591) coupled between the control circuit (540) and the pass device (520), such that an input voltage provided by the control circuit (540) to the pass device (520) is reduced when the storage device (500) is exposed to light;
wherein the pass device (520) comprises a drain coupled to the charge circuit (530), a source coupled to the capacitor (510), and a gate coupled to the control circuit (540), and wherein said input voltage is the gate voltage of the pass device (520);
**characterized in that** the photosensitive diode (591) contains a cathode terminal which is implemented as an n-well region connected to the gate and an anode terminal implemented as a p-substrate of a transponder in which the storage device (500) is included.

8. The method of claim 7, wherein reducing the input voltage causes a layer of holes to be created around the source.

9. The method of claim 7 or 8, wherein the transponder is a radio frequency identification transponder or a near field communication transponder.

## Patentansprüche

1. Speichervorrichtung (500), umfassend:
- einen Kondensator (510), der dazu ausgelegt ist, geladen zu werden;
- eine Ladeschaltung (530), die dazu ausgelegt ist, den Kondensator (510) zu laden;
- eine Durchlassvorrichtung (520), die zwischen der Ladeschaltung (530) und dem Kondensator (510) gekoppelt ist;
- eine Steuerschaltung (540), die dazu ausgelegt ist, die Durchlassvorrichtung (520) zu steuern;
- eine lichtempfindliche Diode (591), die zwischen der Steuerschaltung (540) und der Durchlassvorrichtung (520) gekoppelt ist, sodass eine Eingangsspannung, die durch die Steuerschaltung (540) an die Durchlassvorrichtung (520) bereitgestellt wird, reduziert wird, wenn die Speichervorrichtung (500) Licht ausgesetzt wird;
wobei die Durchlassvorrichtung (520) einen Drain, der mit der Ladeschaltung (530) gekoppelt ist, eine Source, die mit dem Kondensator (510) gekoppelt ist, und ein Gate, das mit der Steuerschaltung (540) gekoppelt ist, umfasst und wobei die Eingangsspannung die Gate-Spannung der Durchlassvorrichtung (520) ist;
**dadurch gekennzeichnet, dass** die lichtempfindliche Diode (591) einen Kathodenanschluss enthält, der als ein mit dem Gate verbundenes n-Wannengebiet implementiert wird, und einen Anodenanschluss, der als p-Substrat eines Transponders implementiert wird, in dem die Speichereinrichtung (500) enthalten ist.

2. Speichervorrichtung (500) nach Anspruch 1, wobei das Reduzieren der Eingangsspannung bewirkt, dass eine Schicht von Löchern um die Source herum erzeugt wird.

3. Speichervorrichtung (500) nach Anspruch 1 oder 2, wobei der Transponder ein Radio-Frequency-Identification-Transponder oder ein Nahfeldkommunikationstransponder ist.

4. Speichervorrichtung (500) nach einem der vorhergehenden Ansprüche, ferner umfassend eine Ausgangsschaltung (550), die zwischen der Durchlassvorrichtung (520) und dem Kondensator (510) gekoppelt ist, wobei die Ausgangsschaltung (550) dazu ausgelegt ist, eine an dem Kondensator (510) vorhandene Spannung auszugeben.

5. Speichervorrichtung (500) nach einem der vorhergehenden Ansprüche, wobei ein Ladezustand des Kondensators (510) aufzubewahrende Informationen, insbesondere ein Bit, repräsentiert.

6. Transponder, insbesondere ein Radio-Frequency-Identification-Transponder oder ein Nahfeldkommunikationstransponder, umfassend die Speichervorrichtung (500) nach einem der vorhergehenden Ansprüche.

7. Verfahren zum Herstellen einer Speichervorrichtung (500), wobei das Verfahren Versehen der Speichervorrichtung mit Folgendem umfasst:
- einen Kondensator (510), der dazu ausgelegt ist, geladen zu werden;
- eine Ladeschaltung (530), die dazu ausgelegt ist, den Kondensator (510) zu laden;
- eine Durchlassvorrichtung (520), die zwischen der Ladeschaltung (530) und dem Kondensator (510) gekoppelt ist;
- eine Steuerschaltung (540), die dazu ausgelegt ist, die Durchlassvorrichtung (520) zu steuern;
- eine lichtempfindliche Diode (591), die zwischen der Steuerschaltung (540) und der Durchlassvorrichtung (520) gekoppelt ist, sodass eine Eingangsspannung, die durch die Steuerschaltung (540) an die Durchlassvorrichtung (520) bereitgestellt wird, reduziert wird, wenn die Speichervorrichtung (500) Licht ausgesetzt wird;
wobei die Durchlassvorrichtung (520) einen Drain, der mit der Ladeschaltung (530) gekoppelt ist, eine Source, die mit dem Kondensator (510) gekoppelt ist, und ein Gate, das mit der Steuerschaltung (540) gekoppelt ist, umfasst und wobei die Eingangsspannung die Gate-Spannung der Durchlassvorrichtung (520) ist;
**dadurch gekennzeichnet, dass** die lichtempfindliche Diode (591) einen Kathodenanschluss enthält, der als ein mit dem Gate verbundenes n-Wannengebiet implementiert wird, und einen Anodenanschluss, der als p-Substrat eines Transponders implementiert wird, in dem die Speichereinrichtung (500) enthalten ist.

8. Verfahren nach Anspruch 7, wobei das Reduzieren der Eingangsspannung bewirkt, dass eine Schicht von Löchern um die Source herum erzeugt wird.

9. Verfahren nach Anspruch 7 oder 8, wobei der Transponder ein Radio-Frequency-Identification-Transponder oder ein Nahfeldkommunikationstransponder ist.

## Revendications

1. Dispositif de stockage (500), comprenant :
- un condensateur (510) configuré pour être chargé ;
- un circuit de charge (530) configuré pour charger ledit condensateur (510) ;
- un dispositif de passage (520) couplé entre le circuit de charge (530) et le condensateur (510) ;
- un circuit de commande (540) configuré pour commander ledit dispositif de passage (520) ;
- une diode photosensible (591) couplée entre le circuit de commande (540) et le dispositif de passage (520), de sorte qu'une tension d'entrée fournie par le circuit de commande (540) au dispositif de passage (520) est réduite lorsque le dispositif de stockage (500) est exposé à la lumière ;
le dispositif de passage (520) comprenant un drain couplé au circuit de charge (530), une source couplée au condensateur (510), et une grille couplée au circuit de commande (540), et ladite tension d'entrée étant la tension de grille du dispositif de passage (520) ;
**caractérisé en ce que** la diode photosensible (591) contient une borne de cathode qui est réalisée sous la forme d'une région de puits N connectée à la grille et une borne d'anode réalisée sous la forme d'un substrat P d'un transpondeur dans lequel le dispositif de stockage (500) est inclus.

2. Dispositif de stockage (500) selon la revendication 1, dans lequel la réduction de la tension d'entrée provoque la création d'une couche de trous autour de la source.

3. Dispositif de stockage (500) selon la revendication 1 ou 2, dans lequel le transpondeur est un transpondeur d'identification radiofréquence ou un transpondeur de communication en champ proche.

4. Dispositif de stockage (500) selon l'une quelconque des revendications précédentes, comprenant en outre un circuit de sortie (550) couplé entre le dispositif de passage (520) et le condensateur (510), le circuit de sortie (550) étant configuré pour délivrer une tension présente sur le condensateur (510).

5. Dispositif de stockage (500) selon l'une quelconque des revendications précédentes, dans lequel un état de charge du condensateur (510) représente une information à conserver, en particulier un bit.

6. Transpondeur, en particulier transpondeur d'identification radiofréquence ou transpondeur de communication en champ proche, comprenant le dispositif de stockage (500) selon l'une quelconque des revendications précédentes.

7. Procédé de fabrication d'un dispositif de stockage (500), le procédé comprenant le fait de doter le dispositif de stockage des éléments suivants :
- un condensateur (510) configuré pour être chargé ;
- un circuit de charge (530) configuré pour charger ledit condensateur (510) ;
- un dispositif de passage (520) couplé entre le circuit de charge (530) et le condensateur (510) ;
- un circuit de commande (540) configuré pour commander ledit dispositif de passage (520) ;
- une diode photosensible (591) couplée entre le circuit de commande (540) et le dispositif de passage (520), de sorte qu'une tension d'entrée fournie par le circuit de commande (540) au dispositif de passage (520) est réduite lorsque le dispositif de stockage (500) est exposé à la lumière ;
le dispositif de passage (520) comprenant un drain couplé au circuit de charge (530), une source couplée au condensateur (510), et une grille couplée au circuit de commande (540), et ladite tension d'entrée étant la tension de grille du dispositif de passage (520) ;
**caractérisé en ce que** la diode photosensible (591) contient une borne de cathode qui est réalisée sous la forme d'une région de puits N connectée à la grille et une borne d'anode réalisée sous la forme d'un substrat P d'un transpondeur dans lequel le dispositif de stockage (500) est inclus.

8. Procédé selon la revendication 7, dans lequel la réduction de la tension d'entrée provoque la création d'une couche de trous autour de la source.

9. Procédé selon la revendication 7 ou 8, dans lequel le transpondeur est un transpondeur d'identification radiofréquence ou un transpondeur de communication en champ proche.
